(19) Europäisches Patentamt
European Patent Office
Office européen des brevets

(11) EP 4 596 638 A1

(12) EUROPEAN PATENT APPLICATION
published in accordance with Art. 153(4) EPC

(43) Date of publication:
06.08.2025 Bulletin 2025/32

(21) Application number: 23872432.2

(22) Date of filing: 27.09.2023

(51) International Patent Classification (IPC):
*C08L 101/12* (2006.01) *C08L 27/12* (2006.01)

(52) Cooperative Patent Classification (CPC):
C08L 27/12; C08L 27/18; C08L 101/12; H05K 1/03

(86) International application number:
PCT/JP2023/035175

(87) International publication number:
WO 2024/071210 (04.04.2024 Gazette 2024/14)

(84) Designated Contracting States:
AL AT BE BG CH CY CZ DE DK EE ES FI FR GB GR HR HU IE IS IT LI LT LU LV MC ME MK MT NL NO PL PT RO RS SE SI SK SM TR
Designated Extension States:
BA
Designated Validation States:
KH MA MD TN

(30) Priority: 28.09.2022 JP 2022155496

(71) Applicant: DAIKIN INDUSTRIES, LTD.
Osaka-shi, Osaka 530-0001 (JP)

(72) Inventors:
- YAMAGUCHI, Shuhei
Osaka-Shi, Osaka 530-0001 (JP)
- FUKUSHIMA, Toshiyuki
Osaka-Shi, Osaka 530-0001 (JP)
- SEKI, Toyomitsu
Osaka-Shi, Osaka 530-0001 (JP)
- KOMORI, Masaji
Osaka-Shi, Osaka 530-0001 (JP)
- OKANISHI, Ken
Osaka-Shi, Osaka 530-0001 (JP)
- YAMAUCHI, Akiyoshi
Osaka-Shi, Osaka 530-0001 (JP)

(74) Representative: Hoffmann Eitle
Patent- und Rechtsanwälte PartmbB
Arabellastraße 30
81925 München (DE)

# (54) COMPOSITION, MOLDED ARTICLE, LAMINATED BODY, AND METHOD FOR PRODUCING COMPOSITION

(57) The disclosure aims to provide a composition capable of suppressing fluororesin agglomeration, which may lead to strands with a poor appearance, even when the proportion of the fluororesin is increased, and also aims to provide a molded article, a laminate, and a method for producing a composition. The disclosure relates to a composition containing a fluororesin A; and a resin B other than the fluororesin A, the resin B having a melt flow rate of 30 g/10 min or higher at a melting point + 8°C, the fluororesin A being a resin satisfying a ratio (a MFR of the fluororesin A)/(a MFR of the resin B) = 0.2 to 10.

EP 4 596 638 A1

## Description

TECHNICAL FIELD

The disclosure relates to compositions, molded articles, laminates, and methods for producing compositions.

BACKGROUND ART

Various studies have been conducted on compositions containing fluororesins and liquid crystal polymers (see, for example, Patent Literatures 1 to 3).

CITATION LIST

- Patent Literature

Patent Literature 1: JP 2001-187833 A
Patent Literature 2: JP 2018-177931 A
Patent Literature 3: JP 2019-065061 A

SUMMARY OF INVENTION

- Technical Problem

The present inventors conducted investigations and found that increasing the proportion of the fluororesin, as in the examples of Patent Literatures 2 and 3, reduces the compatibility between the liquid crystal polymer and the fluororesin, making the fluororesin more susceptible to agglomeration (poor dispersion). Fluororesin agglomeration, which leads to strands with a poor appearance, is preferably avoided as much as possible.
The disclosure aims to provide a composition capable of suppressing fluororesin agglomeration, which may lead to strands with a poor appearance, even when the proportion of the fluororesin is increased, and also aims to provide a molded article, a laminate, and a method for producing a composition.

- Solution to Problem

The disclosure (1) relates to a composition containing: a fluororesin A; and a resin B other than the fluororesin A (hereinafter, also referred to as a "composition of the disclosure"), the resin B having a melt flow rate of 30 g/10 min or higher at a melting point + 8°C, the fluororesin A being a resin satisfying a ratio (a MFR of the fluororesin A)/(a MFR of the resin B) = 0.2 to 10.
The disclosure (2) relates to the composition according to the disclosure (1), wherein the MFR of the fluororesin A is 30 g/10 min or higher.
The disclosure (3) relates to the composition according to the disclosure (1) or (2), wherein the fluororesin A includes at least one selected from the group consisting of a tetrafluoroethylene/perfluoro(alkyl vinyl ether) copolymer and a tetrafluoroethylene/hexafluoropropylene copolymer.
The disclosure (4) relates to the composition according to any one of the disclosures (1) to (3), wherein the resin B includes at least one selected from the group consisting of a liquid crystal polymer, polyetherimide, polyphenylene sulfide, polyaryl ether ketone, polysulfone, and polyethersulfone.
The disclosure (5) relates to the composition according to any one of the disclosures (1) to (4), wherein the fluororesin A is contained in an amount of 10% by volume or more.
The disclosure (6) relates to the composition according to any one of the disclosures (1) to (5), wherein the fluororesin A has a dispersed particle size of 5.0 μm or smaller.
The disclosure (7) relates to the composition according to any one of the disclosures (1) to (6), further containing an additive.
The disclosure (8) relates to a molded article containing the composition according to any one of the disclosures (1) to (7) (hereinafter also referred to as a "molded article of the disclosure").
The disclosure (9) relates to the molded article according to the disclosure (8), which is intended to be used for a low dielectric substrate material.
The disclosure (10) relates to a laminate including: metal foil; and the molded article according to the disclosure

(8) or (9) (hereinafter also referred to as a "laminate of the disclosure").

The disclosure (11) relates to the laminate according to the disclosure (10), wherein the metal foil includes copper.

The disclosure (12) relates to a method for producing a composition containing a fluororesin A and a resin B other than the fluororesin A (hereinafter, also referred to as a "production method of the disclosure"), the resin B having a melt flow rate of 30 g/10 min or higher at a melting point + 8°C, the method including: a MFR adjusting step of adjusting a ratio (a MFR of the fluororesin A)/(a MFR of the resin B) to 0.2 to 10.

The disclosure (13) relates to the method for producing the composition according to the disclosure (12), wherein in the MFR adjusting step, the fluororesin A is obtained by polymerization, kneading, or application of ionizing radiation.

- Advantageous Effects of Invention

The disclosure provides a composition capable of suppressing fluororesin agglomeration, which may lead to strands with a poor appearance, even when the proportion of the fluororesin is increased, and also provides a molded article, a laminate, and a method for producing a composition.

DESCRIPTION OF EMBODIMENTS

The "organic group" herein means a group containing one or more carbon atoms or a group formed by removing one hydrogen atom from an organic compound.

Examples of this "organic group" include

an alkyl group optionally containing one or more substituents,
an alkenyl group optionally containing one or more substituents,
an alkynyl group optionally containing one or more substituents,
a cycloalkyl group optionally containing one or more substituents,
a cycloalkenyl group optionally containing one or more substituents,
a cycloalkadienyl group optionally containing one or more substituents,
an aryl group optionally containing one or more substituents,
an aralkyl group optionally containing one or more substituents,
a non-aromatic heterocyclic group optionally containing one or more substituents,
a heteroaryl group optionally containing one or more substituents,
a cyano group,
a formyl group,
RaO-,
RaCO-,
$RaSO_2$-,
RaCOO-,
RaNRaCO-,
RaCONRa-,
RaOCO-,
$RaOSO_2$-, and
$RaNRbSO_2$-,
wherein Ras are each independently
an alkyl group optionally containing one or more substituents,
an alkenyl group optionally containing one or more substituents,
an alkynyl group optionally containing one or more substituents,
a cycloalkyl group optionally containing one or more substituents,
a cycloalkenyl group optionally containing one or more substituents,
a cycloalkadienyl group optionally containing one or more substituents,
an aryl group optionally containing one or more substituents,
an aralkyl group optionally containing one or more substituents,
a non-aromatic heterocyclic group optionally containing one or more substituents, or
a heteroaryl group optionally containing one or more substituents; and
Rbs are each independently H or an alkyl group optionally containing one or more substituents.

The organic group is preferably an alkyl group optionally containing one or more substituents.

The disclosure is described in detail below.

<Composition of the disclosure>

The composition of the disclosure contains a fluororesin A and a resin B other than the fluororesin A, the resin B having a melt flow rate of 30 g/10 min or higher at a melting point + 8°C, the fluororesin A being a resin satisfying a ratio (a MFR of the fluororesin A)/(a MFR of the resin B) of 0.2 to 10.

The composition of the disclosure can enhance the compatibility between the fluororesin A and the resin B by adjusting the ratio (the MFR of the fluororesin A)/(the MFR of the resin B) to fall within the above range. As a result, even when the proportion of the fluororesin is increased, fluororesin agglomeration, which may lead to strands with a poor appearance, can be suppressed.

Examples of the fluororesin A include a tetrafluoroethylene (TFE)/perfluoro(alkyl vinyl ether) (PAVE) copolymer (PFA), a TFE/hexafluoropropylene (HFP) copolymer (FEP), an ethylene (Et)/TFE copolymer (ETFE), an Et/TFE/HFP copolymer (EFEP), polychlorotrifluoroethylene (PCTFE), a chlorotrifluoroethylene (CTFE)/TFE copolymer, a CTFE/TFE/PAVE copolymer, an Et/CTFE copolymer, polyvinyl fluoride (PVF), polyvinylidene fluoride (PVdF), a vinylidene fluoride (VdF)/TFE copolymer, a VdF/HFP copolymer, a VdF/TFE/HFP copolymer, a VdF/HFP/(meth)acrylic acid copolymer, a VdF/CTFE copolymer, a VdF/pentafluoropropylene copolymer, a VdF/PAVE/TFE copolymer, and a TFE/perfluoroalkyl allyl ether copolymer. The perfluoroalkyl allyl ether is a monomer represented by $CF_2=CFCF_2-O-Rf^4$ (wherein $Rf^4$ is a C1-C5 perfluoroalkyl group).

From the viewpoint of compatibility with the resin B, the fluororesin A preferably includes at least one selected from the group consisting of a tetrafluoroethylene (TFE)/perfluoro(alkyl vinyl ether) (PAVE) copolymer (PFA) and a tetrafluoroethylene (TFE)/hexafluoropropylene (HFP) copolymer (FEP), with FEP being more preferred.

Examples of the perfluorovinyl ether include, but are not limited to, unsaturated perfluoro compounds represented by the following formula (1):

$$CF_2=CF-ORf \qquad (1)$$

wherein Rf is a perfluoroorganic group. The "perfluoroorganic group" herein means an organic group in which all hydrogen atoms bonded to any carbon atom are replaced by fluorine atoms. The perfluoroorganic group may contain ether oxygen.

An example of the perfluorovinyl ether is a perfluoro(alkyl vinyl ether) (PAVE) represented by the formula (1) wherein Rf is a C1-C10 perfluoroalkyl group. The perfluoroalkyl group preferably has 1 to 5 carbon atoms.

Examples of the perfluoroalkyl group in the PAVE include a perfluoromethyl group, a perfluoroethyl group, a perfluoropropyl group, a perfluorobutyl group, a perfluoropentyl group, and a perfluorohexyl group. Preferred is perfluoro(propyl vinyl ether) (PPVE) in which the perfluoroalkyl group is a perfluoropropyl group.

Examples of the perfluorovinyl ether include: those represented by the formula (1) wherein Rf is a C4-C9 perfluoro(alkoxyalkyl) group; those represented by the formula (1) wherein Rf is a group represented by the following formula:

[Chem. 1]

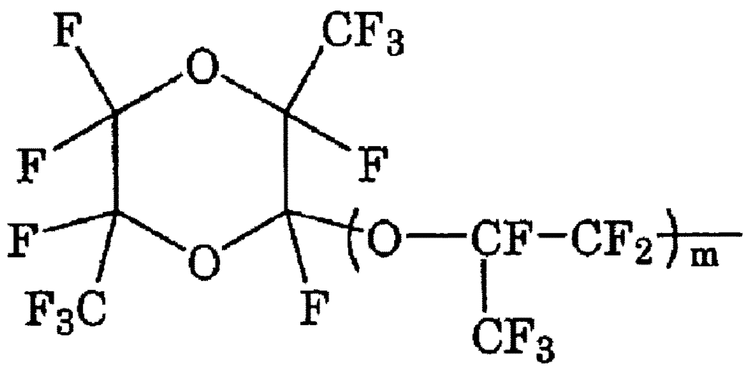

(wherein m is 0 or an integer of 1 to 4); and those represented by the formula (1) wherein Rf is a group represented by the following formula:

[Chem. 2]

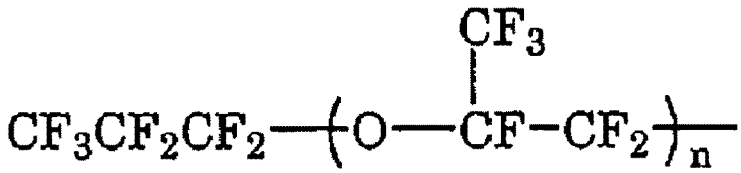

(wherein n is an integer of 1 to 4).

Examples of the (perfluoroalkyl)ethylene include, but are not limited to, (perfluorobutyl)ethylene (PFBE), (perfluorohexyl)ethylene (PFHE), and (perfluorooctyl)ethylene.

The PFA is preferably, but is not limited to, a copolymer in which the mole ratio of the TFE unit to the PAVE unit ((TFE unit)/(PAVE unit)) is 70/30 or higher and lower than 99/1. The mole ratio is more preferably 70/30 or higher and 98.9/1.1 or lower, still more preferably 80/20 or higher and 98.9/1.1 or lower. The PFA is preferably a copolymer containing a monomer unit derived from a monomer copolymerizable with TFE and PAVE in an amount of 0.1 to 10 mol% (the sum of the TFE unit and the PAVE unit is 90 to 99.9 mol%), more preferably 0.1 to 5 mol%, particularly preferably 0.2 to 4 mol%.

Examples of the monomer copolymerizable with TFE and PAVE include HFP, a vinyl monomer represented by the formula (I): $CZ^1Z^2=CZ^3(CF_2)_nZ^4$ (wherein $Z^1$, $Z^2$, and $Z^3$ are the same as or different from each other and each are a hydrogen atom or a fluorine atom; $Z^4$ is a hydrogen atom, a fluorine atom, or a chlorine atom; and n is an integer of 2 to 10), an alkyl perfluorovinyl ether derivative represented by the formula (II): $CF_2=CF\text{-}OCH_2\text{-}Rf^1$ (wherein $Rf^1$ is a C1-C5 perfluoroalkyl group), and an allyl ether monomer represented by the formula (X): $CZ^5Z^6=CZ^7\text{-}CZ^8Z^9\text{-}O\text{-}Rf^4$ (wherein $Z^5$, $Z^6$, and $Z^7$ are the same as or different from each other and each represent a hydrogen atom, a chlorine atom, or a fluorine atom; $Z^8$ and $Z^9$ each are a hydrogen atom or a fluorine atom; and $Rf^4$ is a C1-C5 perfluoroalkyl group). Preferred examples of the allyl ether monomer include $CH_2=CFCF_2\text{-}O\text{-}Rf^4$, $CF_2=CFCF_2\text{-}O\text{-}Rf^4$ (perfluoroalkyl allyl ether), $CF_2=CFCH_2\text{-}O\text{-}Rf^4$, and $CH_2=CHCF_2\text{-}O\text{-}Rf^4$ (wherein $Rf^4$ is the same as that in the formula (X)).

Examples of the monomer copolymerizable with TFE and PAVE further include unsaturated monocarboxylic acids, unsaturated dicarboxylic acids, and acid anhydrides of unsaturated dicarboxylic acids, such as itaconic acid, itaconic anhydride, citraconic anhydride, and 5-norbornene-2,3-dicarboxylic anhydride.

The PFA preferably has a melting point of 180°C to 324°C, more preferably 230°C to 320°C, still more preferably 280°C to 320°C.

The FEP is preferably, but is not limited to, a copolymer in which the mole ratio of the TFE unit to the HFP unit ((TFE unit)/(HFP unit)) is 70/30 or higher and lower than 99/1. The mole ratio is more preferably 70/30 or higher and 98.9/1.1 or lower, still more preferably 80/20 or higher and 98.9/1.1 or lower. The FEP is preferably a copolymer containing a monomer unit derived from a monomer copolymerizable with TFE and HFP in an amount of 0.1 to 10 mol% (the sum of the TFE unit and the HFP unit is 90 to 99.9 mol%), more preferably 0.1 to 5 mol%, particularly preferably 0.2 to 4 mol%.

Examples of the monomer copolymerizable with TFE and HFP include PAVE, a monomer represented by the formula (X), and an alkyl perfluorovinyl ether derivative represented by the formula (II). Examples of the monomer copolymerizable with TFE and HFP also include unsaturated monocarboxylic acids, unsaturated dicarboxylic acids, and acid anhydrides of unsaturated dicarboxylic acids, such as itaconic acid, itaconic anhydride, citraconic anhydride, and 5-norbornene-2,3-dicarboxylic anhydride.

The FEP preferably has a melting point of 150°C to 324°C, more preferably 200°C to 320°C, still more preferably 240°C to 320°C.

The ETFE is preferably a copolymer in which the mole ratio of the TFE unit to the ethylene unit ((TFE unit)/(ethylene unit)) is 20/80 or higher and 90/10 or lower. The mole ratio is more preferably 37/63 or higher and 85/15 or lower, still more preferably 38/62 or higher and 80/20 or lower. The ETFE may be a copolymer containing TFE, ethylene, and a monomer copolymerizable with TFE and ethylene. The ETFE is preferably a copolymer containing a monomer unit derived from a monomer copolymerizable with TFE and ethylene in an amount of 0.1 to 10 mol% (the sum of the TFE unit and the ethylene unit is 90 to 99.9 mol%), more preferably 0.1 to 5 mol%, particularly preferably 0.2 to 4 mol%.

Examples of the monomer copolymerizable with TFE and ethylene include monomers represented by any of the formulas: $CH_2=CX^1Rf^2$, $CF_2=CFRf^2$, $CF_2=CFORf^2$, and $CH_2=C(Rf^2)_2$ (wherein $X^1$ is a hydrogen atom or a fluorine atom; and $Rf^2$ is a fluoroalkyl group optionally containing an ether bond) and monomers represented by the formula (X). Preferred among these are fluorine-containing vinyl monomers represented by any of $CF_2=CFRf^2$, $CF_2=CFORf^2$, and $CH_2=CX^1Rf^2$ and monomers represented by the formula (X). More preferred are HFP, a perfluoro(alkyl vinyl ether) represented by $CF_2=CF\text{-}ORf^3$ (wherein $Rf^3$ is a C1-C5 perfluoroalkyl group), a perfluoro(alkyl allyl ether) represented by $CF_2=CF\text{-}CF_2\text{-}O\text{-}Rf^4$ (wherein $Rf^4$ is a C1-C5 perfluoroalkyl group), and a fluorine-containing vinyl monomer represented by $CH_2=CX^1Rf^2$ wherein $Rf^2$ is a C1-C8 fluoroalkyl group. Examples of the monomer copolymerizable with TFE and ethylene further include unsaturated monocarboxylic acids, unsaturated dicarboxylic acids, and acid anhydrides of unsaturated dicarboxylic acids, such as itaconic acid, itaconic anhydride, citraconic anhydride, and 5-norbornene-2,3-dicarboxylic anhydride.

The ETFE preferably has a melting point of 140°C to 324°C, more preferably 160°C to 320°C, still more preferably 195°C to 320°C.

The amounts of the respective monomer units in the polymer described above can be calculated by appropriate combination of NMR, FT-IR, elemental analysis, and X-ray fluorescence analysis in accordance with the types of the monomers.

The fluororesin A preferably has a thermal decomposition temperature of 330°C or higher, more preferably 350°C or higher, still more preferably 370°C or higher, while preferably 500°C or lower, more preferably 480°C or lower, still more preferably 470°C or lower.

The thermal decomposition temperature of the fluororesin A was determined using a thermal analyzer STA 7200 available from Hitachi High-Tech Corp. The measurement was performed in a nitrogen purge atmosphere at 200 mL/min. A sample in an amount of 10 mg was placed in an aluminum pan and maintained at 25°C for 10 minutes, and the temperature was increased to 600°C at a rate of 10°C/min. The temperature at which 5% of the initial mass was lost (Td5) was defined as the thermal decomposition temperature.

In the case of the fluororesin A that has been reduced in molecular weight by application of ionizing radiation, the thermal decomposition temperature thereof is measured after a degassing operation that follows the application of ionizing radiation.

The fluororesin A may contain 100 to 2000 unstable end groups per $10^6$ main chain carbon atoms. The unstable end groups include -COF and -COOH. The number of unstable end groups is the total number of these groups.

The number of unstable end groups can be determined by infrared spectroscopy. Specifically, first, the fluororesin A is melt-extruded to produce a film having a thickness of 0.25 to 0.3 mm. This film is analyzed by Fourier transform infrared spectroscopy, so that an infrared absorption spectrum of the fluororesin A is obtained. This spectrum is then compared with a base spectrum of a polymer that is completely fluorinated and thus contains no unstable end group. Thereby, a difference spectrum is obtained. Based on the absorption peak of a specific unstable end group in the difference spectrum, the number N of unstable end groups per $10^6$ carbon atoms in the fluororesin A is calculated by the following formula (A):

$$N = I \times K/t \quad (A)$$

wherein

I: absorbance;
K: correction coefficient; and
t: film thickness (mm).

The composition of the disclosure preferably forms a sea-island structure in which the resin B defines a sea component and the fluororesin A defines an island component.

In the composition of the disclosure, the fluororesin A preferably has a dispersed particle size of 5.0 μm or smaller, more preferably 4.0 μm or smaller, still more preferably 2.0 μm or smaller. The lower limit is preferably, but is not limited to, 0.1 μm or greater.

The dispersed particle size of the fluororesin A is determined according to the following procedure.

First, a test piece is obtained by cutting the composition perpendicular to the longitudinal direction, and the cross section is observed with a confocal laser microscope. The resulting microscopic image is analyzed using image analysis software (Image J) to determine the equivalent circle diameter of a dispersed phase. The equivalent circle diameters of 20 dispersed phases were calculated and averaged to determine a dispersed particle size.

The resin B may be any one having a melt flow rate of 30 g/10 min or higher at a melting point + 8°C, and examples of the resin B that can be used include a liquid crystal polymer, polyetherimide, polyphenylene sulfide, polyaryl ether ketone, polysulfone, and polyethersulfone. The resin B preferably includes at least one selected from the group consisting of a liquid crystal polymer, polyetherimide, polyphenylene sulfide, polyaryl ether ketone, polysulfone, and polyethersulfone, with a liquid crystal polymer being particularly preferred.

The liquid crystal polymer may be, but is not limited to, a polymer having a liquid crystallization temperature (i.e., melting point) of 180°C to 380°C, and is preferably a thermotropic liquid crystal polymer that becomes a liquid crystal such as a nematic crystal when heated.

Examples of the liquid crystal polymer include:

a type I liquid crystal polymer (a biphenol/benzoic acid/paraoxybenzoic acid (POB) copolymer, etc.);
a type II liquid crystal polymer (a hydroxynaphthoic acid (HNA)/POB copolymer, etc.); and
a type III liquid crystal polymer (a POB/ethylene terephthalate copolymer, etc.).

Of these, from the viewpoints of kneading temperature and liquid crystal transition temperature, at least one selected from the group consisting of a type I liquid crystal polymer and a type II liquid crystal polymer is preferred, and a type II liquid crystal polymer is more preferred.

The liquid crystal polymer preferably has a melting point of 280°C or higher, more preferably 310°C or higher, while preferably 380°C or lower, more preferably 350°C or lower.

The polyetherimide may be, for example, one having an imide bond and an ether bond in the molecule.

The polyetherimide preferably has a glass transition temperature of 180°C or higher, more preferably 200°C or higher, while preferably 300°C or lower, more preferably 280°C or lower.

The polyphenylene sulfide may be, for example, a resin having a structural unit represented by the following formula. The percentage of the structural unit is preferably 70 mol% or higher.

-(Ph-S)-

In the formula, Ph is a phenylene group, and examples of the phenylene group include p-phenylene, m-phenylene, o-phenylene, an alkyl-substituted phenylene, a phenylsubstituted phenylene, a halogen-substituted phenylene, an amino-substituted phenylene, an amido-substituted phenylene, p,p'-diphenylene sulfone, p,p'-biphenylene, and p,p'-biphenylene ether. Of these, p-phenylene is preferred.

The polyphenylene sulfide preferably has a melting point of 240°C or higher, more preferably 270°C or higher, while preferably 380°C or lower, more preferably 350°C or lower.

Examples of the polyaryl ether ketone include polyetherketone (PEK), polyetheretherketone (PEEK), and polyetherketoneketone (PEKK). Of these, PEEK is preferred.

The polyaryletherketone preferably has a melting point of 320°C or higher, more preferably 340°C or higher, while preferably 400°C or lower, more preferably 380°C or lower.

The polysulfone may be any commonly used polysulfone.

The polysulfone preferably has a glass transition temperature of 180°C or higher, more preferably 200°C or higher, still more preferably 220°C or higher, while preferably 300°C or lower, more preferably 280°C or lower, still more preferably 260°C or lower.

The polyethersulfone may be any commonly used polyethersulfone.

The polyethersulfone preferably has a glass transition temperature of 180°C or higher, more preferably 200°C or higher, still more preferably 220°C or higher, while preferably 300°C or lower, more preferably 280°C or lower, still more preferably 260°C or lower.

The melting points of liquid crystal polymer, polyetherimide, polyphenylene sulfide, and polyaryletherketone each correspond to the maximum value on a heat-of-fusion curve with a temperature-increasing rate of 10°C/min using a differential scanning calorimeter (DSC) .

The glass transition temperatures of polyetherimide, polysulfone, and polyethersulfone can be determined as follows. Specifically, using a differential scanning calorimeter (DSC822e, available from Mettler-Toledo International Inc.), 10 mg of a sample is heated at a rate of 10°C/min to give a DSC curve, and the temperature is read at the intermediate point of two intersections between each of the extension lines of the base lines before and after the secondary transition of the DSC curve and the tangent line at the inflection point of the DSC curve.

The resin B preferably has a thermal decomposition temperature of 330°C or higher, more preferably 350°C or higher, while preferably 600°C or lower, more preferably 550°C or lower.

The thermal decomposition temperature of the resin B was determined using a thermal analyzer STA 7200 available from Hitachi High-Tech Corp. The measurement was performed in a nitrogen purge atmosphere at 200 mL/min. A sample in an amount of 10 mg was placed in an aluminum pan and maintained at 25°C for 10 minutes, and the temperature was increased to 600°C at a rate of 10°C/min. The temperature at which 5% of the initial mass was lost (Td5) was defined as the thermal decomposition temperature.

In the composition of the disclosure, the ratio (the MFR of the fluororesin A)/(the MFR of the resin B) is 0.2 to 10. From the viewpoint of the compatibility between the fluororesin A and the resin B, the ratio is preferably 0.3 or more, more preferably 0.5 or more, while preferably 5 or less, more preferably 3 or less.

When the ratio (the MFR of the fluororesin A)/(the MFR of the resin B) is determined, the MFRs of the respective resins are measured at the same temperature. The measurement temperature is close to the temperature at which the fluororesin A and the resin B are kneaded (the molding temperature of the resin B), and is specifically 325°C.

The MFR of each resin is a value obtained in conformity with ASTM D1238 using a melt indexer (Yasuda Seiki Seisakusho Ltd.), as the mass (g/10 min) of a polymer flowing out of a nozzle (inner diameter: 2 mm, length: 8 mm) per 10 minutes at a temperature of 325°C and a load of 2.16 kg.

The MFR of the fluororesin A at 325°C is not limited as long as it falls within a range that satisfies the above relationship. The MFR is preferably 30 g/10 min or higher, more preferably 50 g/10 min or higher, still more preferably 100 g/10 min or higher, while preferably 1000 g/10 min or lower, more preferably 800 g/10 min or lower, still more preferably 500

g/10 min or lower.

The MFR of the resin B at 325°C is also not limited as long as it falls within a range that satisfies the above relationship. The MFR is preferably 30 g/10 min or higher, more preferably 50 g/10 min or higher, still more preferably 100 g/10 min or higher, while preferably 1000 g/10 min or lower, more preferably 800 g/10 min or lower, still more preferably 500 g/10 min or lower.

The MFR of the resin B at a melting point + 8°C is 30 g/10 min or higher, and is preferably 40 g/10 min or higher, more preferably 60 g/10 min or higher, while preferably 1000 g/10 min or lower, more preferably 800 g/10 min or lower, still more preferably 700 g/10 min or lower.

The MFR of the resin B at 8°C is measured using the same method as that for determining the MFR at 325°C, except for the measurement temperature.

In the composition of the disclosure, the fluororesin A is preferably contained in an amount of 10% by volume or more, more preferably 20% by volume or more, still more preferably 25% by volume or more, while preferably 45% by volume or less, more preferably 40% by volume or less, still more preferably 35% by volume or less.

In the composition of the disclosure, the resin B is preferably contained in an amount of 55% by volume or more, more preferably 60% by volume or more, still more preferably 65% by volume or more, while preferably 90% by volume or less, more preferably 80% by volume or less, still more preferably 75% by volume or less.

In the composition of the disclosure, the total amount of the fluororesin A and the resin B is preferably 70% by volume or more, more preferably 80% by volume or more, still more preferably 90% by volume or more. The upper limit of the total amount is not limited, and the total amount may be 100% by volume.

In the composition of the disclosure, the volume ratio of the fluororesin A to the resin B (fluororesin A/resin B) is preferably 10/90 or more, more preferably 20/80 or more, still more preferably 25/75 or more, while preferably 45/55 or less, more preferably 40/60 or less, still more preferably 35/65 or less.

The composition of the disclosure may contain a fluororesin C, which is different from the fluororesin A. The fluororesin C may be any one that does not satisfy a ratio (a MFR of the fluororesin C)/(the MFR of the resin B) = 0.2 to 10.

When the ratio (the MFR of the fluororesin C)/(the MFR of the resin B) is determined, the MFRs of the respective resins are measured using the same method as that for determining the ratio (the MFR of the fluororesin A)/(the MFR of the resin B).

One or two or more of the fluororesins A may be used, one or two or more of the resins B may be used, and one or two or more of the fluororesins C may be used.

The composition of the disclosure may further contain an additive.

Examples of the additive that can be used include an epoxy compound, an amine compound, an oxazoline compound, and an acid anhydride. Of these, an oxazoline compound is preferred.

The oxazoline compound is any one having one or more oxazoline groups, preferably one having two or more oxazoline groups, more preferably one having two oxazoline groups. Specific examples of the oxazoline compound having two oxazoline groups include 1,3-bis(4,5-dihydro-2-oxazolyl)benzene (1,3-PBO) and its isomer 1,4-PBO.

The oxazoline compound may be an oligomer or polymer having an oxazoline group. A specific example of the polymer having an oxazoline group is poly-2-vinyl-2-oxazoline (Pvozo).

A filler can also be used as an additive. Specific examples of the filler include inorganic compounds such as silica-class compounds (specifically, e.g., crystalline silica, fused silica, spherical fused silica), titanium oxide, zirconium oxide, zinc oxide, tin oxide, silicon nitride, silicon carbide, boron nitride, calcium carbonate, calcium silicate, potassium titanate, aluminum nitride, indium oxide, alumina, antimony oxide, cerium oxide, magnesium oxide, iron oxide, and tin-doped indium oxide (ITO); minerals such as montmorillonite, talc, mica, boehmite, kaolin, smectite, zonolite, vermiculite, and sericite; carbon compounds such as carbon black, acetylene black, ketjen black, and carbon nanotube; metal hydroxides such as aluminum hydroxide and magnesium hydroxide; and glasses such as glass beads, glass flakes, and glass balloons.

In addition to the additives described above, an additive commonly used in resins may be used, such as a cross-linking agent, an antistatic agent, a heat-resistance stabilizer, a foaming agent, a foam nucleating agent, an antioxidant, a surfactant, a photopolymerization initiator, an anti-wear agent, or a surface modifier.

Furthermore, a resin other than the fluororesin A and the resin B may be used as the additive.

In the composition of the disclosure, the additive is preferably contained in an amount of 0.1% by volume or more, more preferably 1% by volume or more, still more preferably 3% by volume or more, while preferably 15% by volume or less, more preferably 12% by volume or less, still more preferably 10% by volume or less.

<Molded article of the disclosure>

The molded article of the disclosure contains the composition of the disclosure.

The molded article of the disclosure can be obtained by molding the composition of the disclosure. The molding may be performed by any common method such as injection molding, blow molding, inflation molding, or vacuum and

pressure molding.

The molded article of the disclosure is suitably used as a dielectric material, in particular, a low dielectric substrate material (e.g., an insulating material).

The "low dielectric substrate material" herein refers to a material having a relative permittivity of 5.0 or lower at 25°C and 10 GHz and a dielectric loss tangent of 0.003 or less at 25°C and 10 GHz, more preferably a material having a relative permittivity of 4.0 or lower at 25°C and 10 GHz and a dielectric loss tangent of 0.002 or less at 25°C and 10 GHz, still more preferably a material having a relative permittivity of 3.5 or lower at 25°C and 10 GHz and a dielectric loss tangent of 0.0012 or less at 25°C and 10 GHz.

When the molded article of the disclosure is used as a dielectric material, its application is not limited. For example, the molded article can be used for a wide range of applications, including electrical and electronic components such as connectors, sockets, relay components, coil bobbins, optical pickups, oscillators, printed wiring boards, and computer-related components; semiconductor manufacturing process-related components such as IC trays and wafer carriers; home electrical product components such as VTRs, televisions, irons, air conditioners, stereos, vacuum cleaners, refrigerators, rice cookers, and lighting fixtures; lighting fixture components such as lamp reflectors and lamp holders; audio product components such as compact discs and speakers; communication device components such as ferrules for optical cables, telephone components, facsimile components, and modems; copierrelated components such as separation claws and heater holders; mechanical components such as impellers, fans, toothed wheels, gears, bearings, motor components, and cases; automotive components such as automotive mechanism components, engine components, engine room components, electrical components, and interior components; cooking utensils such as microwave cooking pots and heat-resistant tableware; building materials and civil engineering materials such as heat insulation or soundproofing materials (e.g., flooring materials, wall materials), support materials (e.g., beams and pillars), and roofing materials; aircraft components; spacecraft components; space equipment components; radiation facility components such as nuclear reactors; marine facility components; cleaning tools; optical equipment components; valves; pipes; nozzles; filters; membranes; medical equipment components and medical materials; sensor parts; and sanitary equipment.

<Laminate of the disclosure>

The laminate of the disclosure includes a metal foil and the molded article of the disclosure.

Examples of the metal of the metal foil include aluminum, iron, silver, gold, and ruthenium. The metal may also be an alloy of these. Of these, copper is preferred. Examples of copper that can be used include rolled copper and electrolytic copper.

The laminate of the disclosure preferably has a thickness of 10 μm to 1000 μm. The molded article of the disclosure in the laminate of the disclosure preferably has a thickness of 1 μm to 100 μm.

The laminate and molded article of the disclosure are each preferably in the form of a sheet having a substantially uniform thickness. When each of these is uneven in thickness, the thickness is determined by measuring the thicknesses at 10 evenly spaced points in the longitudinal direction and averaging the resulting thicknesses.

The laminate of the disclosure may include a different layer in addition to the metal foil and the molded article of the disclosure.

The laminate of the disclosure is suitably used as a circuit board, in particular, a printed circuit board, a laminated circuit board (multilayer board), or a highfrequency circuit board.

The high frequency circuit board is a circuit board that is operable in a high frequency band. The high frequency band may be a band of 1 GHz or more, preferably a band of 3 GHz or more, more preferably a band of 5 GHz or more. The upper limit may be, but is not limited to, a band of 100 GHz or less.

<Production method of the disclosure>

The production method of the disclosure produces a composition containing a fluororesin A and a resin B other than the fluororesin A, the resin B having a melt flow rate of 30 g/10 min or higher at a melting point + 8°C, the method including: a MFR adjusting step of adjusting the ratio (a MFR of the fluororesin A)/(a MFR of the resin B) to 0.2 to 10.

The fluororesin A and the resin B can be the same as those used in the composition of the disclosure described above.

In the MFR adjusting step, the MFR of either resin may be adjusted. Preferably, at least the MFR of the fluororesin A is adjusted to obtain the fluororesin A satisfying a ratio (the MFR of the fluororesin A)/(the MFR of the resin B) = 0.2 to 10.

The MFR may be adjusted by any method, and is preferably adjusted by controlling the molecular weight of the corresponding resin. The molecular weight of the resin may be controlled by employing, for example, a polymerization method that lowers the molecular weight of the resin, a method that lowers the molecular weight of the resin by shearing during kneading, or a method that lowers the molecular weight of the resin by application of ionizing radiation. In other

words, in the MFR adjusting step, the fluororesin A is preferably obtained by polymerization, kneading, or application of ionizing radiation.

The polymerization method to reduce the molecular weight of the resin is not limited and may be performed by appropriately selecting the materials and reaction conditions for achieving the desired molecular weight.

When the molecular weight of the resin is reduced by shear during kneading, the shear rate is preferably 100 $sec^{-1}$ (/sec) or higher. The upper limit is, for example, but is not limited to, 5000 $sec^{-1}$ (/sec) or lower.

The shear rate ($\gamma$) is a value determined, for example, using the following formula:

$$\gamma = \pi Dr/C$$

wherein

D: screw outer diameter (mm);
r: screw rotation speed (rpm); and
C: tip clearance (mm).

Ionizing radiation (radiation having ionizing properties) is radiation that has an ionizing effect on substances, and is classified into particle radiation and electromagnetic radiation. Particle radiation is further classified into charged particle radiation such as $\alpha$-radiation or $\beta$-radiation and uncharged particle radiation such as neutron radiation. Examples of electromagnetic radiation include X-rays and $\gamma$-rays.

Ionizing radiation can also be classified into direct ionizing radiation and indirect ionizing radiation. In this case, charged particle radiation corresponds to direct ionizing radiation, while non-charged particle radiation and electromagnetic radiation correspond to indirect ionizing radiation.

To allow energy to penetrate throughout the resin, the ionizing radiation is preferably indirect ionizing radiation, more preferably electromagnetic radiation, still more preferably $\gamma$-rays.

The fluororesin to which ionizing radiation is to be applied is also preferably a melt-fabricable fluororesin. The term "melt-fabricable" herein means that the polymer can be melted and processed using a conventional processor such as an extruder or an injection molding machine.

Examples of the melt-fabricable fluororesin include PFA, FEP, ETFE, EFEP, PCTFE, and PVdF, which are described above. From the viewpoint of compatibility with the resin B, the melt-fabricable fluororesin preferably includes at least one selected from the group consisting of PFA and FEP, with FEP being more preferred.

It should be appreciated that a variety of modifications and changes in the structure and other details may be made to the aforementioned embodiments without departing from the spirit and scope of the claims.

## EXAMPLES

The disclosure will be described in more detail with reference to examples, but the disclosure is not limited only to these examples.

The materials used in the examples are as follows.

(Fluororesin) (In the following examples, FEP (2) and FEP (3) correspond to the fluororesin A.)

FEP (1) (TFE unit/HFP unit (mole ratio) = 88.0/12.0, MFR (325°C): 5.6 g/10 min, thermal decomposition temperature: 427°C)
FEP (2) (synthesized by the following method, TFE unit/HFP unit/PPVE unit (mole ratio) = 90.9:8.80:0.35, MFR (325°C): 228.0 g/10 min, thermal decomposition temperature: 470°C)
FEP (3) (synthesized by the following method, TFE unit/HFP unit (mole ratio) = 88.0/12.0, MFR (325°C): 270.2 g/10 min, thermal decomposition temperature: 463°C)

(Resin B)

LCP (1) (type II liquid crystal polymer, melting point: 313°C, MFR (325°C): 206.5 g/10 min, MFR (321°C (melting point + 8°C)): 62.4 g/10 min, thermal decomposition temperature: 501°C)
LCP (2) (type II liquid crystal polymer, melting point: 322°C, MFR (325°C): 206.7 g/10 min, MFR (330°C (melting point + 8°C)): 648.4 g/10 min, thermal decomposition temperature: 501°C)

Method for synthesizing FEP (2)

A 4 L glass-lined autoclave was charged with 1100 g of deoxygenated ion-exchanged water, the inside of the autoclave was evacuated, 1100 g of hexafluoropropylene (HFP) was placed into the autoclave, and the temperature inside the autoclave was maintained at 28°C. Next, 8.0 g of perfluoropropyl vinyl ether (PPVE) and 5.0 g of methanol were placed in the autoclave, and tetrafluoroethylene (TFE) was introduced up to 0.89 MPaG with stirring. Then, 8.0 g of di-isopropyl peroxydicarbonate was placed therein, and polymerization was initiated. Since the pressure decreased as the polymerization proceeded, tetrafluoroethylene was additionally introduced to maintain the polymerization pressure at 0.89 MPaG, and the polymerization was performed for 10.6 hours. After the polymerization was completed, the remaining monomer and the solvent were removed, and the product was washed and dried to obtain 74 g of a polymer powder.

Method for synthesizing FEP (3)

An aluminum zipper bag containing 1000 g of FEP pellets was placed on a conveyor belt and irradiated with 500 kGy of $\gamma$-rays while moving around a radiation source. Thereafter, degassing was performed under conditions of 200°C × 4 hours to obtain a sample.

Examples and comparative examples

Under the conditions shown in Table 1, 13.72 g of the resin B and 9.03 g of a fluororesin were kneaded using a circulating twin-screw extruder (Xplore MC15HT: Xplore Instruments) for investigation. The materials were dryblended in advance and then fed from a hopper and kneaded under conditions of 5 min and 500 rpm. The kneading was performed at a temperature shown in Table 1. After kneading, samples were taken as strands.

The cross section of each strand was observed with a laser microscope to evaluate the morphology (dispersion state of the resin) after kneading. All the samples formed a sea-island structure in which the resin B defined a sea component and the fluororesin defined an island component. The dispersed particle size of the island components (fluororesin) in the examples was smaller than that in the comparative examples, which demonstrated that the dispersed state in the examples was better. Also, the strands had a better appearance.

The appearance of the strands was evaluated using the following evaluation criteria.

A: Neither roughness nor agglomeration is observed on the strand surface.
B: Roughness or agglomeration is observed on the strand surface.

[Table 1]

| | Composition (% by volume) | Mixing temperature (°C) | MFR ratio (Fluororesin/Resin B) | Morphology x50 | Dispersed particle size of fluororesin (μm) | Strand appearance |
|---|---|---|---|---|---|---|
| Comparative Example 1 | LCP(1)/FEP(1) (70/30) | 320 | 5.6/206.5 = 0.03 | 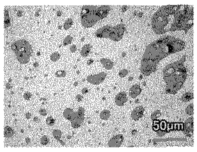 | Not dispersed | B |
| Comparative Example 2 | LCP(1)/FEP(1) (70/30) | 325 | 5.6/206.5 = 0.03 | 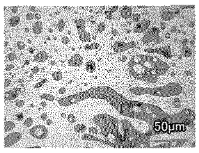 | Not dispersed | B |
| Example 1 | LCP(2)/FEP(2) (70/30) | 325 | 228.0/206.7 = 1.10 | 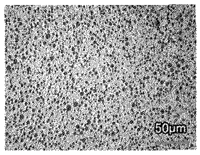 | 3.57 | A |
| Example 2 | LCP(2)/FEP(3) (70/30) | 325 | 270.2/206.7 = 1.31 | 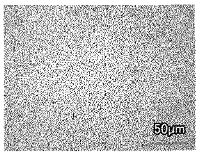 | 1.17 | A |
| Example 3 | LCP(2)/FEP(3) (70/30) | 340 | 270.2/206.7 = 1.31 | 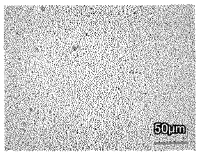 | 1.17 | A |
| Example 4 | LCP(2)/FEP(3) (90/10) | 325 | 270.2/206.7 = 1.31 | 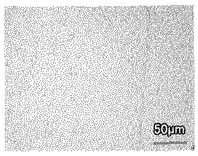 | 0.52 | A |

## Claims

**1.** A composition comprising:

a fluororesin A; and
a resin B other than the fluororesin A, the resin B having a melt flow rate of 30 g/10 min or higher at a melting point + 8°C,
the fluororesin A being a resin satisfying a ratio (a MFR of the fluororesin A)/(a MFR of the resin B) = 0.2 to 10.

**2.** The composition according to claim 1,
wherein the MFR of the fluororesin A is 30 g/10 min or higher.

**3.** The composition according to claim 1 or 2,
wherein the fluororesin A includes at least one selected from the group consisting of a tetrafluoroethylene/perfluoro(alkyl vinyl ether) copolymer and a tetrafluoroethylene/hexafluoropropylene copolymer.

**4.** The composition according to any one of claims 1 to 3, wherein the resin B includes at least one selected from the group consisting of a liquid crystal polymer, polyetherimide, polyphenylene sulfide, polyaryl ether ketone, polysulfone, and polyethersulfone.

**5.** The composition according to any one of claims 1 to 4, wherein the fluororesin A is contained in an amount of 10% by volume or more.

**6.** The composition according to any one of claims 1 to 5, wherein the fluororesin A has a dispersed particle size of 5.0 μm or smaller.

**7.** The composition according to any one of claims 1 to 6, further comprising an additive.

**8.** A molded article comprising the composition according to any one of claims 1 to 7.

**9.** The molded article according to claim 8, which is intended to be used for a low dielectric substrate material.

**10.** A laminate comprising:

metal foil; and
the molded article according to claim 8 or 9.

**11.** The laminate according to claim 10, wherein the metal foil comprises copper.

**12.** A method for producing a composition containing a fluororesin A and a resin B other than the fluororesin A, the resin B having a melt flow rate of 30 g/10 min or higher at a melting point + 8°C, the method comprising: a MFR adjusting step of adjusting a ratio (a MFR of the fluororesin A)/(a MFR of the resin B) to 0.2 to 10.

**13.** The method for producing the composition according to claim 12, wherein in the MFR adjusting step, the fluororesin A is obtained by polymerization, kneading, or application of ionizing radiation.

## INTERNATIONAL SEARCH REPORT

International application No. **PCT/JP2023/035175**

**A. CLASSIFICATION OF SUBJECT MATTER**

***C08L 101/12***(2006.01)i; ***C08L 27/12***(2006.01)i
FI: C08L101/12; C08L27/12

According to International Patent Classification (IPC) or to both national classification and IPC

**B. FIELDS SEARCHED**

Minimum documentation searched (classification system followed by classification symbols)

C08L1/00-101/14; C08K3/00-13/08

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2019/198771 A1 (AGC INC.) 17 October 2019 (2019-10-17) claims, paragraphs [0015], [0022]-[0033], [0042]-[0048], [0064], examples 1-9 | 1-13 |
| A | JP 2021-143330 A (DAIKIN IND LTD) 24 September 2021 (2021-09-24) claims, examples 1-11 | 1-13 |
| A | JP 2022-031187 A (DAIKIN IND LTD) 18 February 2022 (2022-02-18) claims, experiment examples 1-12 | 1-13 |
| A | JP 2022-061008 A (DAIKIN IND LTD) 15 April 2022 (2022-04-15) claims, examples 1-7 | 1-13 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **09 November 2023** | **21 November 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2023/035175**

| Patent document cited in search report | Publication date (day/month/year) | Patent family member(s) | Publication date (day/month/year) |
|---|---|---|---|
| WO 2019/198771 A1 | 17 October 2019 | US 2020/0369878 A1<br>claims, paragraphs [0033], [0043]-[0063], [0096]-[0107], [0145], examples 1-9<br>CN 111954697 A | |
| JP 2021-143330 A | 24 September 2021 | US 2023/0016062 A1<br>claims, examples 1-11<br>WO 2021/182336 A1<br>EP 4108723 A1<br>CN 115210315 A<br>KR 10-2022-0137933 A | |
| JP 2022-031187 A | 18 February 2022 | US 2023/0174780 A1<br>claims, examples 1-12<br>WO 2022/030410 A1<br>EP 4194487 A1<br>KR 10-2023-0034362 A<br>CN 116057113 A | |
| JP 2022-061008 A | 15 April 2022 | WO 2022/071144 A1<br>claims, examples 1-7<br>CN 116323817 A<br>KR 10-2023-0065330 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2001187833 A
- JP 2018177931 A
- JP 2019065061 A